# EUROPEAN PATENT APPLICATION

(11) **EP 4 509 636 A1**
(43) Date of publication of application: **19.02.2025**
(21) Application number: 23905095.8
(22) Date of filing: 12.04.2023
(51) Int. Cl.: C23C 14/56, C23C 14/54, C23C 16/54, C23C 16/52

(54) **DYNAMIC FILM COATING DEVICE AND DYNAMIC FILM COATING METHOD USING SAME**

(30) Priority: 19.12.2022 CN 202211632285
(71) Applicant: Suzhou Maxwell Technologies Co., Ltd., Suzhou, Jiangsu 215200 (CN)
(72) Inventor: XIE, Chuanjia, Suzhou, Jiangsu 215200 (CN); PENG, Xiaolong, Suzhou, Jiangsu 215200 (CN); YU, Liumin, Suzhou, Jiangsu 215200 (CN); CAO, Xinmin, Suzhou, Jiangsu 215200 (CN); ZHU, Hao, Suzhou, Jiangsu 215200 (CN); YANG, Xixi, Suzhou, Jiangsu 215200 (CN)
(74) Representative: Reddie & Grose LLP
(86) International application number: PCT/CN2023/087726
(87) International publication number: WO 2024/130903

(57) **Abstract**

The present invention relates to a dynamic film coating device and a dynamic film coating method using same. The dynamic film coating device comprises a control module, and a buffer cavity, a transition cavity and a film coating cavity which are sequentially arranged in a first direction, wherein the transition cavity comprises at least three detection elements, two adjacent detection elements define one transition section, and a driving mechanism is arranged in the transition section and has a process speed, a transmission speed and a limit speed. The control module is in communication connection with the detection elements and the driving mechanisms, so as to control the driving mechanisms to accelerate to the transmission speed when the detection element close to the film coating cavity detects that a tail of a previous substrate moves away from the film coating cavity, and control the driving mechanisms to decelerate to the process speed when the detection element close to the film coating cavity detects that a head of a latter substrate close to the film coating cavity leaves. The acceleration and transmission speed for catching-up many times are low, such that the broken rate of the substrate is reduced. The interval between adjacent substrates is reduced such that consecutive film coating within an interval of less than 20 mm is realized, thereby reducing waste of target materials, improving the stability of a film coating process, and increasing the yield of products.

## Description

### TECHNICAL FIELD

The present disclosure relates to the technical field of vacuum coating, and particularly relates to a dynamic coating device and a dynamic coating method using the same.

### BACKGROUND

Dynamic coating is a manner of coating a plurality of substrates in continuous movement on line. The substrates enter a coating chamber at a fixed process speed, and are subjected to deposition operations such as physical vapor deposition and chemical vapor deposition in the coating chamber.

At present, a conventional dynamic coating device includes an inlet lock chamber, a buffer chamber, a transition chamber, a coating chamber, a transition chamber, a buffer chamber, and an outlet lock chamber that are linearly arranged, referred to as an inline-type structure. After a second substrate is transferred from the inlet lock chamber to the buffer chamber, the buffer chamber is vacuumed to a specified pressure. When a first substrate of the transition chamber enters the coating chamber at a process speed, the second substrate enters the transition chamber and is subjected to one acceleration, then chases the first substrate at an upper limit speed, and leaves the transition chamber at the process speed. At this time, the first substrate and the second substrate have a smallest spacing therebetween and are not in contact. However, when the production capacity requirement of the dynamic coating device is relatively high, the process speed of the substrate increases accordingly, and an upper limit speed of the transition chamber is limited to transmission stability and mechanical configuration of the substrate. Generally, the upper limit speed is about 40 m/min, and the process speed is 4 m/min, and a length of the transition chamber is slightly greater than a length of the substrate (2 m). A minimum spacing between trays in which the two substrates are located can only be ensured to 200 mm, which is obviously difficult to meet the requirement of a spacing below 20 mm. As the larger spacing between trays means the larger loss of the coating material, for substrates with the length of 2 m and the spacing of 200 mm, it means that 10% of the coating material is wasted due to the spacing between trays. In addition, the process stability of coating is also affected, and there is a risk of wraparound. Furthermore, the relatively high acceleration and upper limit speed result in a relatively high fragment rate of substrate, thus the product yield is relatively low.

### SUMMARY

Accordingly, it is necessary to provide a dynamic coating device and a dynamic coating method using the same to address the problem of the conventional dynamic coating devices that the spacing between adjacent substrates is relatively large and is difficult to control.

The present disclosure provides a dynamic coating device for continuously coating a plurality of substrates. The dynamic coating device includes a control module, and a buffer chamber, a transition chamber, and a coating chamber that are sequentially arranged along a first direction.

The transition chamber includes at least three detection elements arranged along the first direction, one of the at least three detection elements is disposed adjacent to the buffer chamber, and remaining detection elements are disposed adjacent to the coating chamber and are configured to detect information of the substrate, adjacent two detection elements define a transition zone therebetween, a drive mechanism having an adjustable transmission speed is provided in the transition zone, and the transmission speed is no less than a process speed of the substrate in the coating chamber, so as to achieve a chase operation of the substrates. The control module is communicatedly connected to the detection elements and the drive mechanism, the control module is configured to control the drive mechanism to accelerate to the transmission speed when a detection element adjacent to the coating chamber detects that a tail of a previous substrate leaves, and the control module is configured to control the drive mechanism to decelerate to the process speed when the detection element adjacent to the coating chamber detects a head of a latter substrate.

When the foregoing dynamic coating device is in use, a plurality of substrates are fed sequentially into the buffer chamber, a first substrate passes through the transition zone at the process speed, and a latter substrate chasing the first substrate is followed. When adjacent two substrates are in a transition zone, the detection element adjacent to the coating chamber sends a signal to the control module when it detects that the tail of the previous substrate leaves, and the control module controls a corresponding drive mechanism to accelerate to the transmission speed, and the latter substrate is accelerated and is transmitted in the transition zone at the transmission speed. When the detection element detects the head of the latter substrate, the detection element sends a signal to the control module, and the control module controls the drive mechanism to decelerate to the process speed, a chase stroke is then completed. After the latter substrate performs a plurality of chase strokes, the latter substrate enters the coating chamber with a fixed spacing from the previous substrate, and is subjected to a coating operation in the coating chamber. Compared with one chase process in the prior art, the foregoing dynamic coating device uses a plurality of chase processes, such that the acceleration and the transmission speed during the chasing process are relatively small, thus the fragment rate of the substrate is reduced, and the product yield is improved. In addition, in the plurality of chase processes, each acceleration can shorten the spacing between adjacent substrates, such that a continuous coating with a spacing less than 20 mm between adjacent substrates can be achieved conveniently and controllably, thereby reducing a waste of target materials, and improving process stability and product yield of coating.

In one embodiment, lengths of a plurality of transition zone gradually decrease along the first direction.

In one embodiment, in adjacent two transition zones along the first direction, a transmission speed of a previous transition zone away from the coating chamber is greater than or equal to a transmission speed of a latter transition zone adjacent to the coating chamber.

In one embodiment, the transition chamber includes a first chamber and a second chamber, the first chamber is adjacent to the buffer chamber and is integrally connected to the second chamber along the first direction, two ends of the first chamber along the first direction are respectively provided with one detection element, at least one detection element is provided in the second chamber, and one detection element is disposed at an end of the second chamber adjacent to the coating chamber along the first direction.

In one embodiment, the first chamber and the second chamber are of an integrated structure, and a length of the transition chamber along the first direction is greater than a length of the substrate.

In one embodiment, a length of the substrate is greater than a length of the second chamber and less than a length of the first chamber along the first direction, and the first chamber and the second chamber are integrally connected.

In one embodiment, a length ratio of the second chamber to the first chamber along the first direction is greater than 0.2.

In one embodiment, a number of the detection elements in the second chamber is less than or equal to 5.

In one embodiment, the detection elements are sensors or stroke switches.

In addition, the present disclosure further provides a dynamic coating method for the dynamic coating device according to any one of the foregoing technical solutions, including:
S1, providing a plurality of substrates, feeding the plurality of substrates sequentially into the buffer chamber, in which a first substrate passes through the transition zone at the process speed;
S2, controlling, by the control module, the latter substrate to perform one chase stroke, which including the following steps:
S21, collecting, by a detection element adjacent to the coating chamber, a location information of the previous substrate, and transmitting the location information to the control module when the tail of the previous substrate leaves at the process speed;
S22, controlling, by the control module, a drive mechanism in a transition zone where the previous substrate leaves to accelerate to a transmission speed;
S23, collecting and detecting, by the detection element, a location information of the latter substrate, and transmitting the location information to the control module when the detection element detects the head of the latter substrate; and
S24, controlling, by the control module, a drive mechanism in a transition zone where the latter substrate is located to decelerate to the process speed; and
S3, repeating step S2, and after the latter substrate performs a plurality of chase strokes, subjecting the latter substrate to the coating operation in the coating chamber with the fixed spacing from the previous substrate.

In the foregoing dynamic coating method, in step S1, a plurality of substrates is firstly provided and fed sequentially into the buffer chamber, a first substrate passes through the transition zone at the process speed, and a latter substrate chasing the first substrate is followed. Then in step S2, the latter substrate is controlled by the control module to perform one chase stroke when adjacent two substrates are in a transition zone. In step S21, the detection element adjacent to the coating chamber collects a location information of the previous substrate, and transmits the location information to the control module when the tail of the previous substrate leaves at the process speed. In step S22, the control module controls a drive mechanism to accelerate to the transmission speed, and the latter substrate is accelerated and is transmitted at the transmission speed in the transition zone. In step S23, the detection element collects and detects a location information of the latter substrate, and transmits the location information to the control module when the detection element detects the head of the latter substrate. In step S24, the control module controls the drive mechanism to decelerate to the process speed. Then in step S3, after the latter substrate performs a plurality of chase strokes, the latter substrate enters the coating chamber with a fixed spacing from the previous substrate, and is subjected to a coating operation in the coating chamber. Compared with one chase process in the prior art, the foregoing dynamic coating method uses a plurality of chase processes, such that the acceleration and the transmission speed during the chasing process are relatively small, thus the fragment rate of the substrate is reduced, and the product yield is improved. In addition, in the plurality of chase processes, each acceleration can shorten the spacing between adjacent substrates, such that a continuous coating with a spacing less than 20 mm between adjacent substrates can be achieved conveniently and controllably, thereby reducing a waste of target materials, and improving process stability and product yield of coating.

### BRIEF DESCRIPTION OF THE DRAWINGS

FIGS. 1(a) to 1(f) are schematic views of a transmission process of a conventional dynamic coating device.
FIG. 2 is a schematic view of a dynamic coating device according to an embodiment of the present disclosure.
FIG. 3 is a schematic view of a dynamic coating device according to another embodiment of the present disclosure.
FIGS. 4(a) to 4(e) are schematic views of a transmission process of a dynamic coating device according to an embodiment of the present disclosure.
FIG. 5 is a flowchart of a dynamic coating method for a dynamic coating device according to an embodiment of the present disclosure.

Reference Numerals:
the prior art:
01, conventional dynamic coating device; 011, first buffer chamber; 0111, first detection element; 012, second buffer chamber; 0121, second detection element; 013, transition chamber; 0131, third detection element; 014, coating chamber; 0141, coating source; 015, first valve; 016, second valve; 017, third valve;
02, first substrate; 03, second substrate; 04, third substrate.

The present disclosure:
10, dynamic coating device; X, first direction;
100, buffer chamber; 110, first buffer chamber; 120, second buffer chamber;
200, transition chamber; 210, detection element; 211, first detection element; 212, second detection element; 213, third detection element; 214, fourth detection element; 215, fifth detection element; 220, transition zone; 221, first transition zone; 222, second transition zone; 223, third transition zone; 224, fourth transition zone; 230, first chamber; 240, second chamber;
300, coating chamber; 310, coating source;
20, substrate; 21, previous substrate; 22, latter substrate.

### DETAILED DESCRIPTION

In order to make the above objectives, features and advantages of the present disclosure more obvious and understandable, specific embodiments of the present disclosure are described in detail below with reference to the accompanying drawings. In the following description, many specific details are set forth in order to fully understand the present disclosure. However, the present disclosure can be implemented in many other ways different from those described herein, and those skilled in the art can make similar improvements without departing from the connotation of the present disclosure. Therefore, the present disclosure is not limited by the specific embodiments disclosed below.

In the description of the present disclosure, it should be understood that the orientation or position relationship indicated by the terms "center", "longitudinal", "transverse", "length", "width", "thickness", "upper", "lower", "front", "back", "left", "right", "vertical", "horizontal", "top", "bottom", "inner", "outer", "clockwise", "counterclockwise", "axial", "radial", "circumferential", etc. are based on the orientation or position relationship shown in the accompanying drawings and are merely intended to facilitate the description of the present disclosure and simplify the description, rather than indicating or implying that the indicated device or element must have a particular orientation or be constructed and operated in a specific orientation, and therefore cannot be construed as limitation of the present disclosure.

In addition, the terms "first" and "second" are used for descriptive purposes only, which cannot be construed as indicating or implying a relative importance, or implicitly specifying the number of the indicated technical features. Therefore, the features defined with "first" and "second" may explicitly or implicitly include at least one of the features. In the description of the present disclosure, "a plurality of" means at least two, such as two, three, etc., unless specifically defined otherwise.

In the present disclosure, unless otherwise explicitly specified and defined, the terms "mounted", "coupled", "connected" and "fixed" should be understood in a broad sense, such as, it can be a fixed connection, or a detachable connection, or integrated; it can be a mechanical connection, or an electrical connection; it can be a direct connection, an indirect connection through an intermediate medium, it can be an internal connection between two elements, or an interaction between two elements. For those of ordinary skill in the art, the specific meanings of the above terms in the present disclosure can be understood according to the specific situation.

In the present disclosure, unless otherwise explicitly specified and defined, a first feature being "on" or "under" a second feature may mean that the first feature is in direct contact with the second feature, or the first feature is in indirect contact with the second feature via an intermediate medium. Furthermore, the first feature being "over", "above", or "on top of" the second feature may mean that the first feature is directly above or obliquely above the second feature, or only means that the first feature is horizontally higher than the second feature. The first feature being "below", "underneath", or "under" the second feature may mean that the first feature is directly underneath or obliquely underneath the second feature, or only means that the first feature is horizontally lower than the second feature.

It should be noted that, when an element is referred to as "being fixed to" or "being disposed on" another element, the element may be directly on another element or there may be an intermediate element therebetween. When an element is referred to as "connected to" another element, the element may be directly connected to another element or there may be an intermediate element therebetween. The terms "vertical", "horizontal", "upper", "lower", "left", "right", and similar expressions used herein are for illustrative purposes only and are not meant to be the only means of implementation.

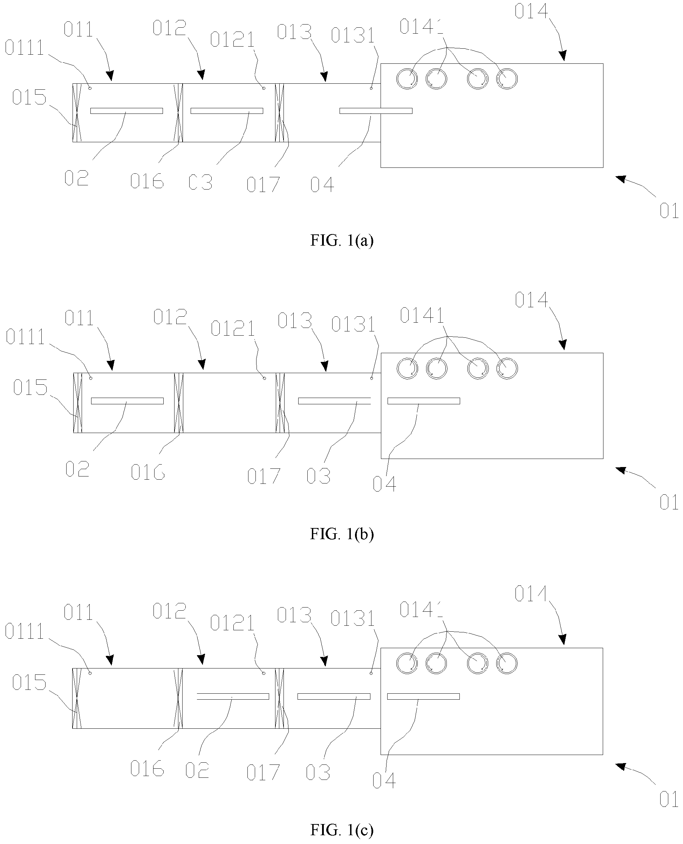

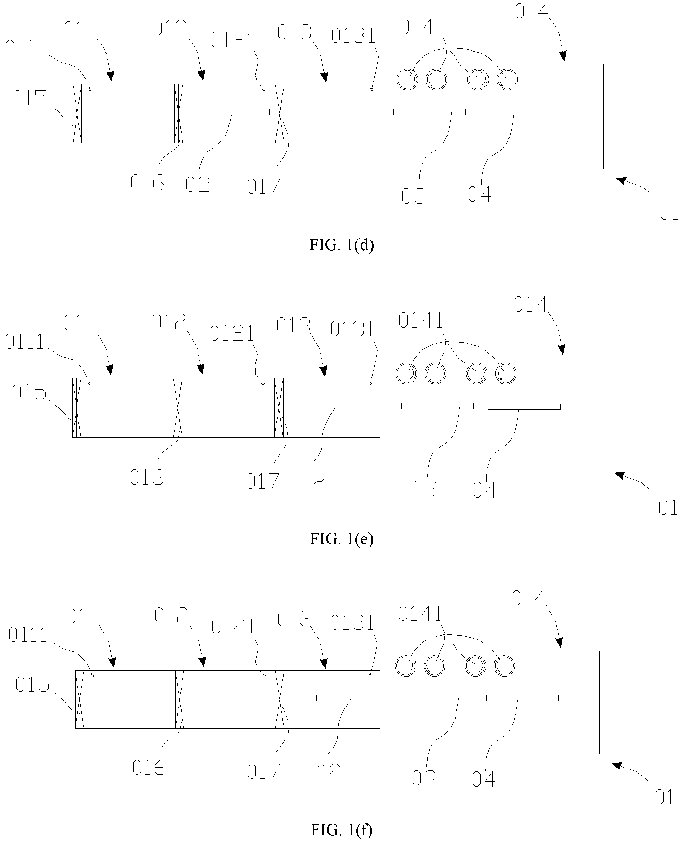

As shown in FIGS. 1(a) to 1(f), a conventional dynamic coating device 01 includes a control module, a first buffer chamber 011, a second buffer chamber 012, a transition chamber 013, and a coating chamber 014. A first detection element 0111 is provided at an end of the first buffer chamber 011 away from the coating chamber 014. A second detection element 0121 is provided at an end of the second buffer chamber 012 adjacent to the coating chamber 014. A third detection element 0131 is provided at an end of the transition chamber 013 adjacent to the coating chamber 014. A plurality of coating sources 0141 are provided in the coating chamber 014. A specific transmission process of the conventional dynamic coating device 01 is as follows. As shown in FIG. 1(a), the first substrate 02 is transmitted from an atmospheric side to the first buffer chamber 011, and the first detection element 0111 detects a location information of the first substrate 02. After detecting that a tail of the first substrate 02 enters the first buffer chamber 011, the control module controls to close the first valve 015, and the first buffer chamber 011 is vacuumed to a medium vacuum. As shown in FIG. 1(b), after the first buffer chamber 011 reaches a specified threshold pressure, the second detection element 0121 detects a location information of the second substrate 03, and after detecting that the second substrate 03 in the second buffer chamber 012 leaves the second buffer chamber 012, the control module controls the second valve 016 to open. As shown in FIG. 1(c), the first substrate 02 is transmitted to the second buffer chamber 012 and the second valve 016 is closed, and then the second buffer chamber 012 is vacuumed to a high vacuum. As shown in FIG. 1(d), after the second buffer chamber 012 reaches a specified threshold pressure, the third detection element 0131 detects the location information of the second substrate 03, and after detecting that the second substrate 03 in the transition chamber 013 leaves the transition chamber 013 and enters the coating chamber 014 at a constant process speed, the third valve 017 is opened. As shown in FIG. 1(e), the first substrate 02 is accelerated to transmit to the third buffer chamber at a limit speed, chasing the previous second substrate 03. As shown in FIG. 1(f), after the third detection element 0131 detects a head of the first substrate 02, the first substrate 02 is decelerated to the process speed, such that the two substrates have a smallest spacing therebetween and are not in contact. The first substrate 02, the second substrate 03, and the third substrate 04 located in the coating chamber 014 are moved forward continuously at the same speed for coating. When the production capacity requirement of the conventional dynamic coating device 01 is relatively high, the process speed increases accordingly, and an upper limit speed of the transition chamber 013 is limited to transmission stability and mechanical configuration of the substrate. Generally, the upper limit speed is about 40 m/min. When the process speed is 4 m/min, it is assumed that a length of the transition chamber 013 is 2 m, and a minimum spacing between trays in which the first substrate 02 and the second substrate 03 are located can only be ensured to 200 mm, which is obviously completely unacceptable for the general requirement of a spacing of 20 mm.

The technical solutions provided in the embodiments of the present disclosure are described below with reference to the accompanying drawings.

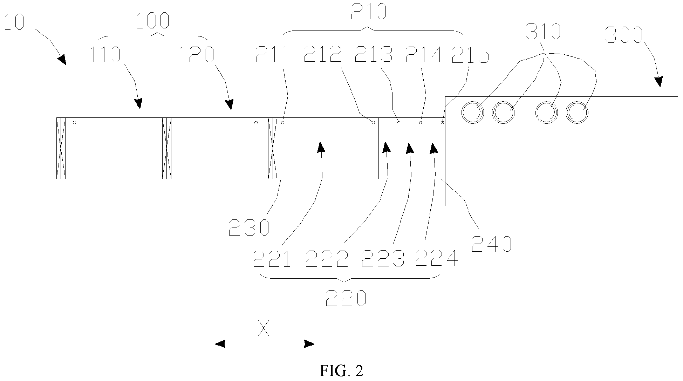

As shown in FIGS. 2, 3, 4(a) to 4(e), the present disclosure provides a dynamic coating device 10 for continuously coating a plurality of substrates 20. The dynamic coating device 10 includes a control module, a buffer chamber 100, a transition chamber 200, and a coating chamber 300. The buffer chamber 100, the transition chamber 200, and the coating chamber 300 are sequentially arranged along a first direction X, which is a moving direction of the substrate 20 in the buffer chamber 100. An end of the substrate 20 adj acent to the coating chamber is a head of the substrate 20, and an end thereof away from the coating chamber is a tail of the substrate 20. The buffer chamber 100 and the coating chamber 300 adopt the structural form in the conventional dynamic coating device 01, i.e., the buffer chamber 100 includes the first buffer chamber 110 and the second buffer chamber 120, and a plurality of coating sources 310 are provided in the coating chamber 300, which is not changed and details will not be described again.

The transition chamber 200 includes at least three detection elements 210. The number of the detection elements 210 can be three, four, five, six, or more. In specific setting, the detection elements 210 can be sensors, for example, infrared light sensors or optical sensors. Alternatively, the detection elements 210 can be stroke switches, for example, direct acting stroke switches or roller stroke switches, such that position detection of the substrate 20 can be conveniently and reliably achieved by using a simple structural component. Certainly, the number and specific structure of the detection elements 210 are not limited thereto, and can be other structural form that can meet the requirement.

These detection elements 210 are sequentially arranged along a first direction X. One detection element 210 is disposed adjacent to the buffer chamber 100 and is configured to detect whether a substrate enters the transition chamber 100. The remaining detection elements 210 are disposed adjacent to the coating chamber 300 and are configured to detect information of the substrate 20, so as to feed back a chase signal. For example, as shown in FIG. 2, a first detection element 211, a second detection element 212, a third detection element 213, a fourth detection element 214, and a fifth detection element 215 are disposed in the transition chamber 200 along the first direction X. The first detection element 211 is configured to detect whether a latter substrate 20 completely enters the transition chamber 100. The second detection element 212, the third detection element 213, the fourth detection element 214, and the fifth detection element 215 detect the information of the substrate 20 and use this information as determining information for the substrate 20 to chase. Adjacent two detection elements 210 define a transition zone 220 therebetween. A drive mechanism is provided in each transition zone 220. The drive mechanism has an adjustable transmission speed, which is no less than a process speed of the substrate in the coating chamber, so as to achieve a chase operation between adjacent substrates. In specific setting, the drive mechanism can be of a roller drive structure, or of a conveyor drive structure. The drive mechanism is of the structure form in the conventional dynamic coating device 01, which is not changed and details will not be described again. For example, the process speed is 4 m/min, and the transmission speed is 4 m/min to 40 m/min. In addition, due to transmission stability and mechanical configuration of the substrate 20, a maximum speed of the transmission speed is a limiting speed, for example, the limiting speed may be 40 m/min.

The transition zones 220 can be set in a variety of manners, in a preferred embodiment, lengths of the plurality of transition zone 220 gradually decrease along the first direction X. For example, when the number of the detection elements 210 is five, the number of the transition zones 220 is four. A first transition zone 221, a second transition zone 222, a third transition zone 223, and a fourth transition zone 224 are arranged sequentially along the first direction X. A length of the first transition zone 221 is greater than a length of the second transition zone 222. The length of the second transition zone 222 is greater than a length of the third transition zone 223. The length of the third transition zone 223 is greater than a length of the fourth transition zone 224. In the foregoing dynamic coating device 10, the lengths of the transition zones gradually decrease along the first direction X, so as to shorten a length of the transition chamber 200 as much as possible, and reduce space occupied by the transition chamber 200, thereby reducing a cost of the dynamic coating device 10.

The transition zones 220 can be set in a variety of manners, in a preferred embodiment, in adjacent two transition zones 220 along the first direction X, a transmission speed of a previous transition zone away from the coating chamber 300 is greater than a transmission speed of a latter transition zone adj acent to the coating chamber 300. Alternatively, in adjacent two transition zones 220, the transmission speed of the previous transition zone away from the coating chamber 300 is equal to the transmission speed of the latter transition zone adjacent to the coating chamber 300. Continue with the above embodiment, a speed of the drive mechanism in the first transition zone 221 is greater than a speed of the drive mechanism in the second transition zone 222. The speed of the drive mechanism in the second transition zone 222 is greater than a speed of the drive mechanism in the third transition zone 223. The speed of the drive mechanism in the third transition zone 223 is greater than a speed of the drive mechanism in the fourth transition zone 224. In the foregoing dynamic coating device 10, by decomposing the limit speed obtained after one acceleration in the prior art into several relatively low chasing speeds, the transmission stability can be significantly improved, thereby reducing the defect rate of product.

The control module is communicatively connected to the detection elements 210 through wire, WiFi and the like. The detection elements 210 transmit the collected location information of the substrate 20 to the control module, and the control module is communicatively connected to the drive mechanism through wire, WiFi and the like. The control module generates a control signal by an internal logical operation according to the received location information of the substrate 20, and controls the drive mechanism to accelerate or decelerate through the control signal. The specific logical operation of the control module is as follows: the control module controls the drive mechanism to accelerate to the transmission speed when the detection element 210 adjacent to the coating chamber 300 detects that a tail of the previous substrate 21 leaves, and the control module controls the drive mechanism to decelerate to the process speed when the detection element 210 detects a head of the latter substrate 22. In specific setting, the control module can be a PLC or and a singlechip microcomputer, and the control module can be integrated into an external control panel. Certainly, a structural form of the control module is not limited thereto, and can be other forms that can meet the requirement.

When the foregoing dynamic coating device 10 is in use, a plurality of substrates 20 are fed sequentially into the buffer chamber 100, a first substrate 20 passes through the transition zone 220 at the process speed, and a latter substrate 20 chasing the first substrate 20 is followed. When adjacent two substrates 20 are in a transition zone 220, the detection element 210 adjacent to the coating chamber 300 sends a signal to the control module when it detects that the tail of the previous substrate 21 leaves, and the control module controls a drive mechanism to accelerate to the transmission speed, and the latter substrate 20 is accelerated and is transmitted in the transition zone 220 at the transmission speed. When detecting the head of the latter substrate 20, the detection element 210 sends a signal to the control module, and the control module controls the drive mechanism to decelerate to the process speed, a chase stroke is then completed. After the latter substrate 22 performs a plurality of chase strokes, the latter substrate 22 enters the coating chamber 300 with a fixed spacing from the previous substrate 21, and is subjected to a coating operation in the coating chamber 300. Compared with one chase process in the prior art, the foregoing dynamic coating device 10 uses a plurality of chase processes, such that the acceleration and the transmission speed during the chasing process are relatively small, thus the fragment rate of the substrate 20 is reduced, and the product yield is improved. In addition, in the plurality of chase processes, each acceleration can shorten the spacing between adjacent substrates 20, such that a continuous coating with a spacing less than 20 mm between adjacent substrates can be achieved conveniently and controllably, thereby reducing a waste of target materials, and improving process stability and product yield of coating.

As shown in FIGS. 2, 3, 4(a) to 4(e), the transition zones 220 can be set in a variety of manners. In a preferred embodiment, the transition chamber 200 includes a first chamber 230 and a second chamber 240. The first chamber 230 is adjacent to the buffer chamber 100 along the first direction X relative to the second chamber 240. The first chamber 230 and the second chamber 240 are arranged along the first direction X, and the first chamber 230 and the second chamber 240 are integrally connected.

Specifically, the first chamber 230 and the second chamber 240 are of an integrated structure. A length of the transition chamber 200 along the first direction X is greater than a length of the substrate 20. For example, a length ratio of the transition chamber 200 to the substrate 20 can be 1.2, 1.3, 1.4, 1.5, 1.6, 1.7, 1.8, or the like. In the foregoing dynamic coating device 10, the transition chamber 200 is limited to the integrated structure, the transition chamber 013 of the conventional dynamic coating device 01 can be replaced, thus facilitating preparation and assembly. The length of the transition chamber 200 is also limited, so as to match the conventional substrate 20.

Specifically, the length of the substrate 20 is greater than a length of the second chamber 240 and less than a length of the first chamber 230 along the first direction X. The first chamber 230 and the second chamber 240 are integrally connected. For example, the first chamber 230 and the second chamber 240 are directly connected, or the first chamber 230 and the second chamber 240 are integrally connected through snap-fit connection or concaveconvex fitting. In the foregoing dynamic coating device 10, the first chamber 230 may be a transition chamber 013 in the conventional dynamic coating device 01. The second chamber 240 is added between the transition chamber 013 and the coating chamber 014 based on the conventional transition chamber 013, so as to save chamber material and costs, and maximize use of the conventional coating chamber 300.

Two ends of the first chamber 230 along the first direction are respectively provided with one detection element 210. At least one detection element 210 is provided in the second chamber 240. The specific number of the detection elements 210 can be one, two, three, four, or more. One detection element 210 in the second chamber 240 is disposed at an end of the second chamber 240 adjacent to the coating chamber 300 along the first direction X. Specifically, for example, only the detection elements 211, 212, and 213 are provided, in which the detection element 211 is configured to detect whether the substrate 20 completely enters the transition chamber, and the detection elements 212 and 213 are configured to detect information about the substrate 20 and use this information as determining information for the substrate 20 to chase.

Specifically, a length ratio of the second chamber 240 to the first chamber 230 along the first direction X is greater than 0.2. For example, the length ratio of the second chamber 240 to the first chamber 230 is 0.3, 0.4, 0.5, 0.6, 0.7, or 0.8. In the foregoing dynamic coating device 10, the length ratio of the second chamber 240 to the first chamber 230 is adjusted, so as to facilitate the control of the acceleration and the transmission speed of the transmission mechanism, thereby reducing the fragment rate of product and improving the yield of product.

Specifically, the number of detection elements 210 in the second chamber 240 is less than or equal to 5, and a specific number of detection elements 210 may be one, two, three, four, or five, such that the substrate 20 can chase in the second chamber 240, and the drive mechanism can be provided conveniently and quickly.

In the foregoing dynamic coating device 10, a chase scheme is described as an example based on rough calculation of the following conditions and without considering the acceleration and deceleration time: the length of the substrate 20 is 2000 mm; the process speed is 4 m/min; the length of the first chamber 230 is slightly greater than the length of the substrate 20; the first detection element 211 and the second detection element 212 are provided in the first chamber 230 along the first direction X; the third detection element 213, the fourth detection element 214, and the fifth detection element 215 are provided in the second chamber 240 along the first direction X; the length of the second transition zone 222 is 400 mm; the length of the third transition zone 223 is 250 mm; and the length of the fourth transition zone 224 is 150 mm.

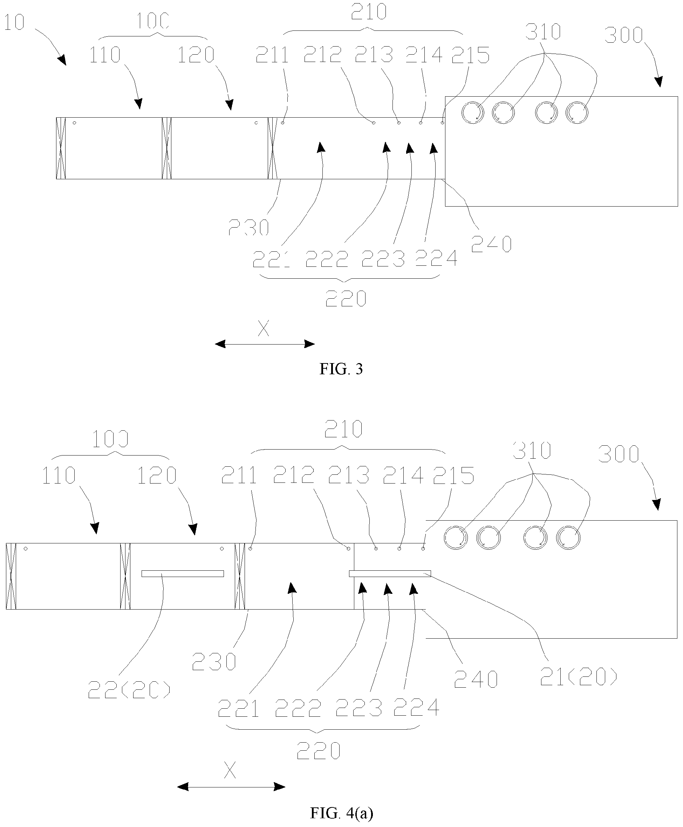

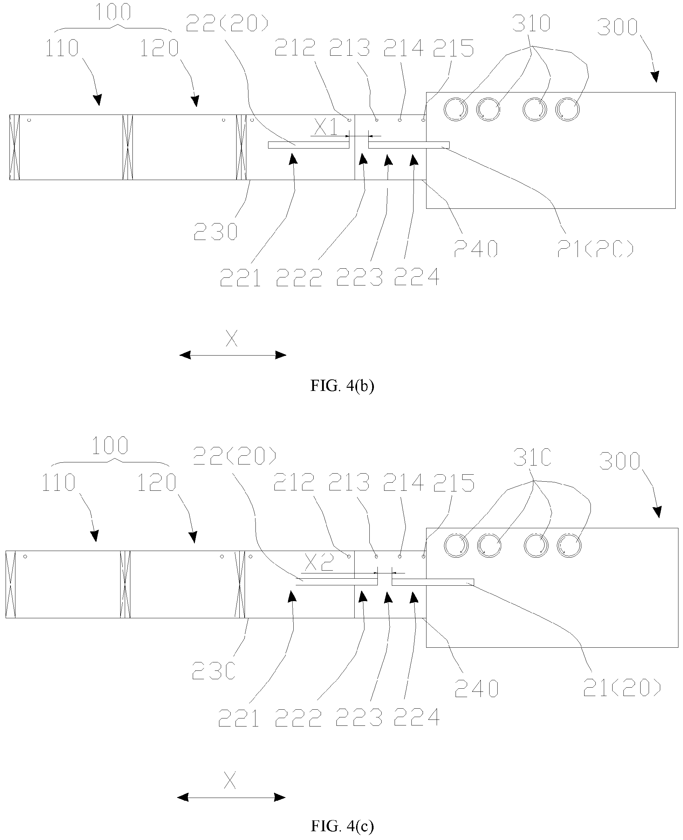

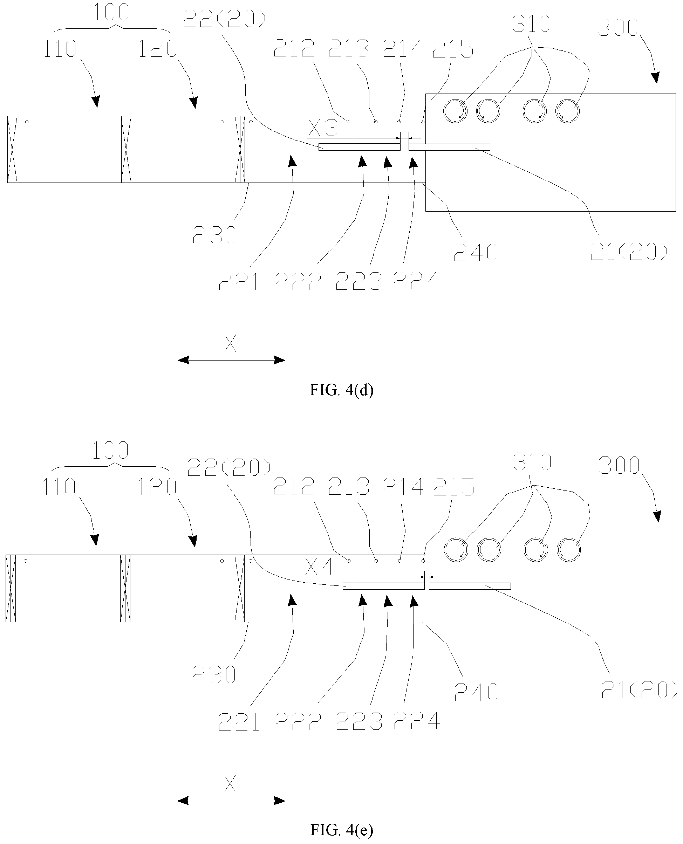

As shown in FIG. 4(a), the previous substrate 21 is transmitted in the first chamber 230 at the process speed. When the tail of the previous substrate 21 passes through the second detection element 212 and leaves the first chamber 230, the control module controls the drive mechanism in the first chamber 230 to accelerate, and the latter substrate 22 is accelerated by the drive mechanism to 25 m/min. As shown in FIG. 4(b), when the head of the second substrate 22 reaches a position of the second detection element 212, the latter substrate 22 is decelerated to the process speed, and is transmitted forward along with the previous substrate 21 at the process speed with a fixed spacing X1 (for example, about 320 mm) from the tail of the previous substrate 21. As shown in FIG. 4(c), when the tail of the previous substrate 21 leaves the third detection element 213, the control module controls the drive mechanism of the second transition zone 222 to accelerate, and the latter substrate 22 is accelerated again by the drive mechanism to 15 m/min to chase the previous substrate 21. When the head of the latter substrate 22 reaches a position of the third detection element 213, the latter substrate 22 is decelerated to the process speed and keeps a fixed spacing X2 (for example, about 85 mm) from the tail of the previous substrate 21. As shown in FIG. 4(d), when the tail of the previous substrate 21 leaves the fourth detection element 214, the control module controls the drive mechanism of the third transition zone 223 to accelerate, and the latter substrate 22 is accelerated again by the drive mechanism to 10 m/min to chase the previous substrate 21. When the head of the latter substrate 22 reaches a position of the fourth detection element 214, the latter substrate 22 is decelerated to the process speed and keeps a fixed spacing X3 (for example, about 34 mm) from the tail of the previous substrate 21. As shown in FIG. 4(e), when the tail of the previous substrate 21 leaves the fifth detection element 215, the control module controls the drive mechanism of the fourth transition zone 224 to accelerate, and the latter substrate 22 is accelerated again by the drive mechanism to 8 m/min to chase the previous substrate 21. When the head of the latter substrate 22 reaches a position of the fifth detection element 215, the latter substrate 22 is decelerated to the process speed and keeps a fixed spacing X4 (for example, about 17 mm) from the tail of the previous substrate 21, and enters the coating chamber for coating at a uniform speed. The foregoing example shows that four stages of chase can relatively ensure a relatively small transmission speed in each chase process, thus the fragment rate of the substrate 20 is reduced, and the product yield is improved. In addition, in the plurality of chase processes, each acceleration can shorten the spacing between adjacent substrates 20, such that a continuous coating with a spacing less than 20 mm between adjacent substrates can be achieved conveniently and controllably, thereby reducing a waste of target materials, and improving process stability and product yield of coating.

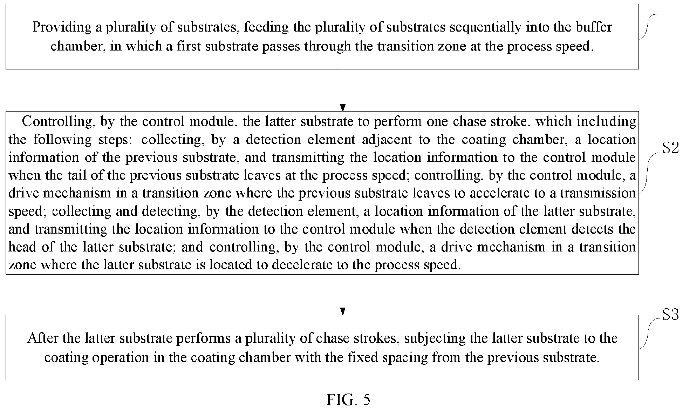

In addition, as shown in FIGS. 4(A) to 4(e) and FIG. 5, the present disclosure further provides a dynamic coating method for the dynamic coating device 10 according to any one of the foregoing technical solutions, including:
S1, the plurality of substrates 20 are provided and fed sequentially into the buffer chamber 100. The first substrate 20 passes through the transition zone 220 at the process speed. In specific setting, an initial start-up speed of the drive mechanism in the transition zone 220 is the process speed.
S2, the latter substrate 22 is controlled by the control module to perform one chase stroke, which including the following steps:
S21, the detection element 210 adjacent to the coating chamber 300 collects a location information of the previous substrate 21, and transmits the location information to the control module when the tail of the previous substrate 21 leaves at the process speed. In specific setting, when the detection element 210 is a photoelectric sensor, an electrical signal is obtained by detecting whether light is shielded by the substrate 20, such that the location information of the substrate 20 can be obtained.
S22, the control module controls a drive mechanism in a transition zone 220 where the previous substrate 21 leaves to accelerate to the transmission speed. In specific setting, the control module determines whether to change the rotation speed of the drive mechanism according to the received electrical signal of the photoelectric sensor.
S23, the detection element 210 collects and detects a location information of the latter substrate 22, and transmits the location information to the control module when the detection element 210 detects the head of the latter substrate 22.
S24, the control module controls a drive mechanism in a transition zone 220 where the latter substrate 22 is located to decelerate to the process speed.
S3, step S2 is repeated, and after the latter substrate 22 performs a plurality of chase strokes, the latter substrate 22 is subjected to the coating operation in the coating chamber 300 with the fixed spacing from the previous substrate 21. In specific setting, the chase strokes of the latter substrate 22 can be twice, three times, or more than three times.

In the foregoing dynamic coating method, in step S1, a plurality of substrates 20 is firstly provided and fed sequentially into the buffer chamber 100, a first substrate 20 passes through the transition zone 220 at the process speed, and a latter substrate 20 chasing the first substrate 20 is followed. Then in step S2, the latter substrate 22 is controlled by the control module to perform one chase stroke when adjacent two substrates 20 are in a transition zone 220. In step S21, the detection element 210 adjacent to the coating chamber 300 collects a location information of the previous substrate 21, and transmits the location information to the control module when the tail of the previous substrate 21 leaves. Specifically, the previous substrate 21 leaves at the process speed. In step S22, the control module controls a drive mechanism to accelerate to the transmission speed, and the latter substrate 22 is accelerated and is transmitted in the transition zone 220 at the transmission speed. In step S23, the detection element 210 collects and detects a location information of the latter substrate 22, and transmits the location information to the control module when the detection element 210 detects the head of the latter substrate 22. In step S24, the control module controls the drive mechanism to decelerate to the process speed. Then, in step S3, after the latter substrate 22 performs a plurality of chase strokes, the latter substrate 22 enters the coating chamber 300 with a fixed spacing from the previous substrate 21, and is subjected to a coating operation in the coating chamber 300. Compared with one chase process in the prior art, the foregoing dynamic coating method uses a plurality of chase processes, such that the acceleration and the transmission speed during the chasing process are relatively small, thus the fragment rate of the substrate 20 is reduced, and the product yield is improved. In addition, in the plurality of chase processes, each acceleration can shorten the spacing between adjacent substrates 20, such that a continuous coating with a spacing less than 20 mm between adjacent substrates can be achieved conveniently and controllably, thereby reducing a waste of target materials, and improving process stability and product yield of coating.

Each of the technical features of the aforementioned embodiments can be combined arbitrarily. To simplify the description, not all the possible combinations of the technical features in the aforementioned embodiments are described. However, all of the combinations of these technical features should be considered as within the scope of the present disclosure, as long as such combinations do not contradict with each other.

The aforementioned embodiments merely illustrate several embodiments of the present disclosure, and the description thereof is specific and detailed, but it shall not be constructed as limiting the scope of the present disclosure. It should be noted that, for those ordinary skilled in the art, several variations and improvements can be made without departing from the concept of the present disclosure, which are all within the protection scope of the present disclosure. Therefore, the protection scope of the present disclosure shall be defined by the appended claims.

## Claims

1. A dynamic coating device for continuously coating a plurality of substrates, the dynamic coating device comprising a control module, and a buffer chamber, a transition chamber, and a coating chamber that are sequentially arranged along a first direction;
wherein the transition chamber comprises at least three detection elements arranged along the first direction, one of the at least three detection elements is disposed adjacent to the buffer chamber and is configured to detect whether a substrate enters the transition chamber, and remaining detection elements are disposed adjacent to the coating chamber and are configured to detect information of the substrate to feed back a chase signal, adjacent two detection elements define a transition zone therebetween, a drive mechanism having an adjustable transmission speed is provided in the transition zone, and the transmission speed is no less than a process speed of the substrate in the coating chamber, so as to achieve a chase operation between adjacent substrates;
wherein the control module is communicatedly connected to the detection elements and the drive mechanism, the control module is configured to control the drive mechanism to accelerate to the transmission speed when a detection element adjacent to the coating chamber detects that a tail of a previous substrate leaves, and the control module is configured to control the drive mechanism to decelerate to the process speed when the detection element detects a head of a latter substrate; and
wherein after the latter substrate performs a plurality of chase strokes, the latter substrate is subjected to a coating operation in the coating chamber with a fixed spacing from the previous substrate.

2. The dynamic coating device according to claim 1, wherein lengths of a plurality of transition zone gradually decrease along the first direction.

3. The dynamic coating device according to claim 1, wherein in adjacent two transition zones along the first direction, a transmission speed of a previous transition zone away from the coating chamber is greater than or equal to a transmission speed of a latter transition zone adjacent to the coating chamber.

4. The dynamic coating device according to claim 1, wherein the transition chamber comprises a first chamber and a second chamber, the first chamber is adjacent to the buffer chamber and is integrally connected to the second chamber along the first direction, two ends of the first chamber along the first direction are respectively provided with one detection element, at least one detection element is provided in the second chamber, and one detection element is disposed at an end of the second chamber adjacent to the coating chamber along the first direction.

5. The dynamic coating device according to claim 4, wherein the first chamber and the second chamber are of an integrated structure, and a length of the transition chamber along the first direction is greater than a length of the substrate.

6. The dynamic coating device according to claim 4, wherein a length of the substrate is greater than a length of the second chamber and less than a length of the first chamber along the first direction, and the first chamber and the second chamber are integrally connected.

7. The dynamic coating device according to claim 4, wherein a length ratio of the second chamber to the first chamber along the first direction is greater than 0.2.

8. The dynamic coating device according to claim 4, wherein a number of the detection elements in the second chamber is less than or equal to 5.

9. The dynamic coating device according to claim 1, wherein the detection elements are sensors or stroke switches.

10. A dynamic coating method for the dynamic coating device according to any one of claims 1 to 9, comprising:
S1, providing the plurality of substrates, feeding the plurality of substrates sequentially into the buffer chamber, wherein a first substrate passes through the transition zone at the process speed;
S2, controlling, by the control module, the latter substrate to perform one chase stroke, which comprising the following steps:
S21, collecting, by a detection element adjacent to the coating chamber, a location information of the previous substrate, and transmitting the location information to the control module when the tail of the previous substrate leaves at the process speed;
S22, controlling, by the control module, a drive mechanism in a transition zone where the previous substrate leaves to accelerate to a transmission speed;
S23, collecting and detecting, by the detection element, a location information of the latter substrate, and transmitting the location information to the control module when the detection element detects the head of the latter substrate; and
S24, controlling, by the control module, a drive mechanism in a transition zone where the latter substrate is located to decelerate to the process speed; and
S3, repeating step S2, and after the latter substrate performs a plurality of chase strokes, subjecting the latter substrate to the coating operation in the coating chamber with the fixed spacing from the previous substrate.
